# EUROPEAN PATENT SPECIFICATION

(11) **EP 4 334 487 B1**
(45) Date of publication and mention of the grant of the patent: **18.11.2026**
(21) Application number: 22726646.7
(22) Date of filing: 29.04.2022
(51) Int. Cl.: C23C 14/00, C23C 14/08, C23C 14/54, C23C 14/58, H01G 9/20, H10K 30/15, H10K 71/16, H10K 71/00, H10K 85/50, H10K 30/50

(54) **METHOD FOR MANUFACTURING A SOLAR CELL AND SOLAR CELL**
VERFAHREN ZUR HERSTELLUNG EINER SOLARZELLE SOWIE SOLARZELLE
PROCÉDÉ DE FABRICATION D'UNE CELLULE SOLAIRE ET CELLULE SOLAIRE

(30) Priority: 05.05.2021 EP 21172248
(43) Date of publication of application: 13.03.2024
(73) Proprietor: Syddansk Universitet, 5230 Odense M (DK)
(72) Inventor: MADSEN, Morten, 6400 Sønderborg (DK); AHMADPOUR, Mehrad, 6400 Sønderborg (DK)
(74) Representative: Høiberg P/S
(86) International application number: PCT/EP2022/061538
(87) International publication number: WO 2022/233737

(56) References cited:
- EP-A1- 3 499 597
- WO-A1-2020/248063
- US-A1- 2009 091 033
- US-A1- 2014 060 648
- US-A1- 2015 064 483
- US-A1- 2016 111 224

## Description

### FIELD OF THE INVENTION

The present invention relates to a method of producing a metal oxide layer on a substrate, to a method of producing an optoelectronic device or an electrochemical device and to an optoelectronic device comprising a metal oxide layer.

### BACKGROUND OF THE INVENTION

Metal oxide thin films are widely used for several applications, for example as coatings in microelectronic devices, sensors, photoconductors, filters and photovoltaics.

Properties and correspondent performances of metal oxide thin films are strongly dependent on the presence of surface defects within the metal oxide thin films or layers.

In particular, metal oxide layers surface defects may be crucial as catalyzing undesired reactions within thin film solar cell applications.

In photovoltaics applications, metal oxide thin films are frequently used as interlayers in flexible thin film solar cells where they are interfaced to organic and hybrid active layers in order to efficiently extract charges out of the cells. Chemical surface reactions at the metal oxide and organic/hybrid interfaces may significatively hamper the lifetime of the solar cell.

In that, there is a need for a method for minimizing or avoiding surface defects, in particular for solar cell application, such as in organic photovoltaic devices.

Hence a method of producing a metal oxide layer minimizing the presence or avoiding the formation of surface defects would be advantageous.

### OBJECT OF THE INVENTION

An object of the present invention is to provide a method of producing a metal oxide layer minimizing the presence or avoiding the formation of surface defects.

An object of the present invention may also be seen as to provide a method of producing an optoelectronic device or an electrochemical device comprising a metal oxide layer minimizing the presence or avoiding the formation of surface defects.

A further object of the present invention may be seen as to provide an optoelectronic device comprising a metal oxide layer having minimal surface defects.

An object of the present invention may also be seen as to provide an alternative to the prior art.

In particular, it may be seen as an object of the present invention to provide a method of producing a metal oxide layer minimizing the presence or avoiding the formation of surface defects that solves the above-mentioned problems of the prior art by controlling the cooling protocol at the end of a sputtering process.

### SUMMARY OF THE INVENTION

The above-described object and several other objects are intended to be obtained in a first aspect of the invention by providing a method of producing a metal oxide layer on a substrate, the method comprising: providing a substrate into a deposition chamber; heating the substrate at a predefined temperature for a predefined period of time and maintaining the heating; introducing at least one carrier gas and at least one reacting gas; sputtering the metal oxide layer under a ratio of the carrier gas and the reacting gas, thereby forming the metal oxide layer of a desired thickness; cooling the sputtered substrate to a preferred temperature and under a flow of at least one processing gas for a preferred period of time, thereby preventing formation of, or passivating surface defects of the sputtered metal oxide layer.

According the first aspect of the invention the method of producing a metal oxide layer prevents formation of or passivate possible surface defects by controlling the cooling protocol at the end of a sputtering process. Possible surface defects may be, for example, oxygen vacancies within the metal oxide layer.

According to the method of the invention, a substrate, such as a transparent substrate, for example a transparent conductive substrate, is firstly introduced into a deposition chamber.

Transparent is herein defined as having an average transmittance higher than 80% with the Visible (VIS) spectrum, i.e. between 380 nm to 800 nm.

A transparent conductive substrate may be a glass substrate coated with a layer of conductive material, such as a transparent conductive oxide (TCO), for example Indium Tin Oxide (ITO).

In some embodiments, for applications in which transparency of the substrate is not needed, the substrate may be have transmittance lower 80% with the VIS spectrum.

The deposition chamber may be a vacuum chamber, such as an ultra-high vacuum sputter deposition chamber.

In the vacuum chamber, reduced pressure may be achieved through the use of a rough-pump and a fine-pump. The substrate is heated at a predefined temperature for a predefined period of time prior sputtering and the heat is maintained while sputtering.

A rough-pump is herein defined as a pump operating in the first stage of a high vacuum or a ultra high vaccum system operating within a range above 1 x 10⁻³ mbar.

A fine-pump is herein defined as a pump operating in the second stage of a high vacuum or a ultra high vaccum system operating in a range below 1 x 10⁻³ mbar.

In some embodiments, the predefined temperature of the substrate is between 80 ⁰C and 600 ⁰C, such as at 150 ⁰C, such as at 400 ⁰C or at 350 ⁰C.

In some embodiments, the predefined period of time is between 1 and 120 minutes, such as 10, 20, 40, 50 or 60 minutes, for example 30 minutes.

The sputtering or reactive sputtering is then started by closing the valve for the fine-pump and by introducing at least one carrier gas and at least one reacting gas.

The at least one carrier gas may be or comprise an inert gas, such as Argon gas. The at least one carrier gas is generally introduced at a high flow rate.

After power is applied to the sputter-head to ignite the plasma, the carrier gas flow may be gradually reduced while the power is increased so as to reach the desired set point.

The at least one reacting gas may be introduced in the vacuum chamber through a controlled valve when the flow of the at least one carrier gas and the power reach the desired value. Upon stabilization of the deposition rate, the deposition of the metal oxide layer begins.

The at least one reacting gas may comprise oxygen gas.

The deposition of the metal oxide layer may be performed in constant power, constant flow of the at least one reacting gas or constant rate depending on the applications of the metal oxide layers to be produced. The sputtering or the deposition of sputtered particles of the metal oxide layer may therefore occur for a desired period of time and may be carried under different ratio of carrier gas and reacting gas, such as a constant ratio of the carrier gas and of the reacting gas, thereby forming the metal oxide layer having a desired thickness.

In some other embodiments, the desired period of time is between 1 and 120 minutes, such as 10, 20, 40, 50 or 60 minutes, for example 30 minutes.

The metal oxide layer thickness may be between 1 and 30 nm, such as 15 nm.

In some embodiments, the pressure, while sputtering is maintained under 5x10⁻³ mbar. In some further embodiments, the pressure is maintained between 5x10⁻² and 3x10⁻⁴ mbar, while sputtering.

In some embodiments, the ratio of reacting gas is between 1% to 50%, such as 25%, over reacting gas and carrier gas, i.e. over the total amount of gas.

The heating of the substrate during deposition have the advantage of producing a preferred type of crystallization of the metal oxide layers.

In some embodiments, the metal oxide may be a transition metal oxide (TMO), such as titanium oxide (TiOₓ).

When the TMO use is TiOₓ a preferred crystallization form may be a combination of a dominant rutile phase with small area of anatase phase.

In some other embodiments, the metal oxide may be tin oxide, (SnOₓ).

When the thickness of the metal oxide layer reaches the desired value, the valve controlling the introduction of the at least one reacting gas is shut.

During the cooling of the substrate at a preferred temperature and during a preferred period of time, the valve controlling the at least one processing gas is opened, allowing the flow of the at least one processing gas within the vacuum chamber, while the power starts decreasing.

In some embodiments, the preferred temperature is lower than 100 ⁰C.

In some other embodiments, the preferred period of time is between 1 and 120 minutes, such as 10, 20, 40, 50 or 60 minutes, for example 30 minutes.

In some embodiments, the flow of the at least one processing gas is between 1 and 20 sccm, such as 5 sccm at a preferred pressure between 10⁻⁴ mbar and 10⁻² mbar, such as 10⁻³ mbar.

Standard cubic centimeters per minute (SCCM) is the unit of flow measurement indicating cubic centimeters per minute (cm³/min) in standard conditions.

The at least one processing gas is the at least one carrier gas or the at least one reacting gas.

In some embodiments, the flow may be a constant flow of the at least one processing gas.

In some other embodiments, the flow may be 0 sccm, i.e. there may be no flow of the at least one processing gas.

When the power reaches 0%, the valve controlling the at least one carrier gas is shut, and the fine-pump engages so as to pump down the vacuum chamber. When the fine-pump turns off, the heating of the substrate is stopped.

Once the substrate is back at room temperature, this process is concluded and the sputtered substrate can be retrieved.

The introduction of the cooling step following the reactive sputtering process, i.e. in-line with the same coating process, prevents the formation of, or passivates, surface defects of the sputtered metal oxide layer.

The reaction of the fresh and still heated surface of the sputtered films with the at least one processing gas provides metal oxide thin films generating very stable interfaces with additional layers subsequently deposited.

The optimization of this process depends on the optimized reactive sputtering process parameters, i.e. background pressure, temperature and reactive gas pressure, which controls composition and microstructure of the metal oxide layer.

In a second aspect, the invention relates to a method of producing an optoelectronic device or an electrochemical device, the method comprising: producing a metal oxide layer on a substrate according to the first aspect of the invention; depositing a layer of light harvesting material onto the metal oxide layer; depositing a contact layer onto the layer of light harvesting material; depositing a metal contact onto the contact layer.

The contact layer may be a hole transport layer (HTL).

The substrate may be a transparent substrate, such as a transparent conductive substrate, or a TCO.

In a third aspect, the invention relates to an optoelectronic device comprising a metal oxide layer produced, such as sputtered, according to the first aspect of the invention.

In a fourth aspect, the invention relates to an optoelectronic device, such as a solar cell, for an organic solar cell, produced according to the second aspect of the invention.

In general, photocatalytic degradation of active layers in organic solar cells or Organic Photovoltaics (OPVs) is mainly due to interface reaction between the active layer and the metal oxide layer. The interface reaction is catalyzed by oxygen vacancies within the metal oxide surface.

The method of the invention introducing a cooling or passivation step achieves the reduction of surface defects improving performance and stability of the metal oxide layers used in OPVs.

Through the cooling or passivation step following the reactive sputtering process, i.e. in-line in the same coating process, the metal oxide thin films produced generate a stable interface to the organic and hybrid active layers subsequently deposited in the construction of an organic solar cell.

In a fifth aspect, the invention relates to an optoelectronic device, such as a non-fullerene acceptor based organic solar cell, comprising: a transparent conductive substrate; an electron transport layer (ETL) located onto the transparent conductive substrate, such as a metal oxide layer produced according to any of the first aspect of the invention; a layer of light harvesting material, such as a combination of light harvesting organic materials; a hole transport layer (HTL) located onto the layer of light harvesting material; a metal contact located onto the HTL.

The light harvesting material may be a perovskite-based material.

The metal oxide layers of the invention may also be used in different type of electrochemical devices, such as energy storage devices or light emitting devices, for example Organic Light Emitting Diodes (OLEDs)

A further advance of the metal oxides layers of the invention is that they can be produced in an in-line reactive sputtering process, such as a Roll-to-Roll (R2R) vacuum sputtering.

The first and other aspects and embodiments of the present invention may each be combined with any of the other aspects and embodiments. These and other aspects of the invention will be apparent from and elucidated with reference to the embodiments described hereinafter.

### BRIEF DESCRIPTION OF THE FIGURES

The method of producing a metal oxide layer, an optoelectronic device or an electrochemical device and the optoelectronic device comprising a metal oxide layer of the invention will now be described in more details with regard to the accompanying figures. The figures show one way of implementing the present invention and are not to be construed as being limiting to other possible embodiments falling within the scope of the attached claim set.
Figure 1 is a flow chart of the method of producing a metal oxide layer according to some embodiments of the invention.
Figure 2 is a flow chart of the method of producing an optoelectronic device or an electrochemical device according to some other embodiments of the invention.
Figure 3 is a schematic illustration of an organic solar cell according to some embodiments of the invention comprising PBDB-T:ITIC as donor/acceptor light harvesting composition.
Figure 4 is a schematic illustration of an organic solar cell according to some embodiments of the invention comprising perovskite as light harvesting material.
Figure 5 is a graph showing current-voltage characteristics of a solar cells having a configuration as described in figure 4.
Figure 6 is a graph showing the External Quantum Efficiency (EQE) vs wavelength for solar cells having a configuration as described in figure 4.
Figure 7 is a graph showing the evolution of normalized Power Conversion Efficiency (PCE) (stability), over time at 1 sun light illumination and at Room Temperature (RT), i.e. between 20 and 25 ⁰C, of the solar cells having a configuration as described in figure 4.
Figure 8 is a graph showing the evolution of normalized PCE (stability), over time at 1 sun light illumination and at RT, for two solar cells, one using the titanium dioxide layer of the invention and a configuration as in figure 4, the other one using a standard ZnO layer in a correspondent configuration.

### DETAILED DESCRIPTION OF AN EMBODIMENT

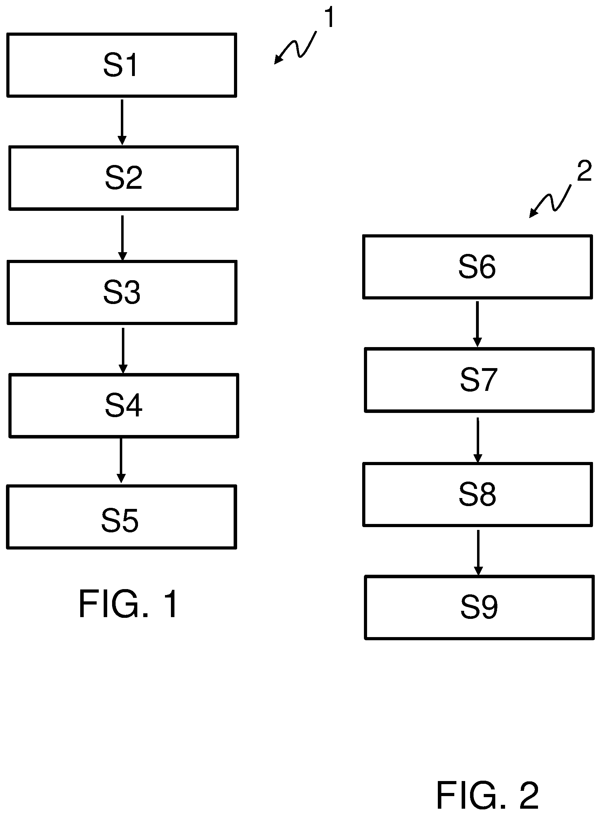

Figure 1 is a flow chart of the method 1 of producing a metal oxide layer on a substrate.

The method 1 comprises the steps of:
- S1, providing a substrate into a deposition chamber;
- S2, heating the substrate at a predefined temperature for a predefined period of time and maintaining the heating;
- S3, introducing at least one carrier gas and at least one reacting gas;
- S4, sputtering the metal oxide layer under a ratio of the carrier gas and the reacting gas, thereby forming the metal oxide layer of a desired thickness;
- S5, cooling the sputtered substrate to a preferred temperature and under a flow of at least one processing gas for a preferred period of time, thereby preventing formation of, or passivating possible surface defects of the sputtered metal oxide layer.

Figure 2 is a flow chart of the method 2 of producing an optoelectronic device or an electrochemical device.

The method 2 comprises the steps of:
- S6, producing a metal oxide layer on a substrate according to method 1;
- S7, depositing a layer of light harvesting material onto the metal oxide layer;
- S8, depositing a contact layer onto the layer of light harvesting material;
- S9, depositing a metal contact onto the contact layer.

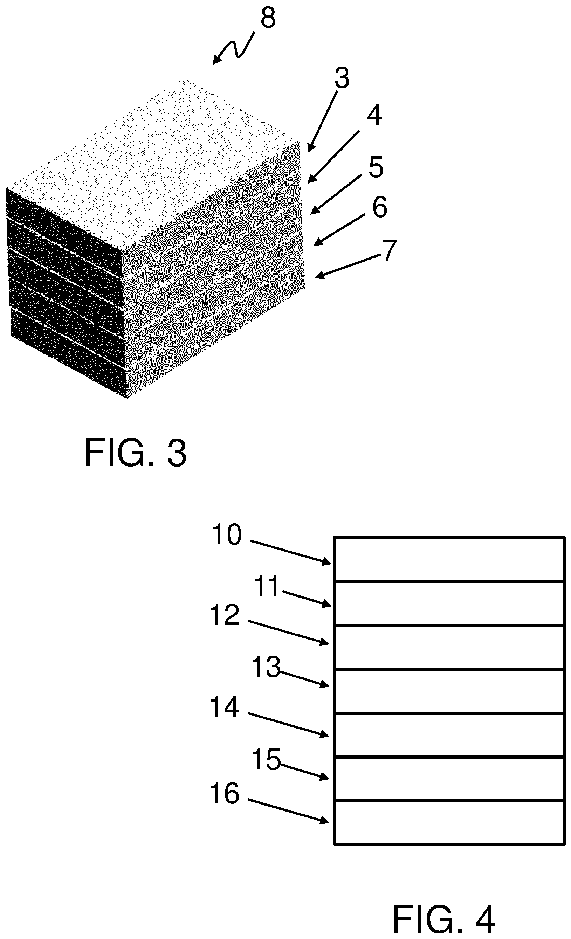

Figure 3 is a schematic illustration of an organic solar cell 8 according to some embodiments of the invention.

The organic solar cell 8 comprises a conductive glass substrate 7 coated with a thin layer of ITO. A Ti oxide layer 6 of few nanometers is deposited onto the ITO layer 6 according to the method of the first aspect of the invention.

A layer of PBDB-T:ITIC 5 is spin coated onto the Ti oxide layer 6.

Optimal thickness may be achieved by repeated spin coating at predetermined speed and for a predetermined period of time.

A further layer of MoO₃ 4 is deposited onto the PBDB-T:ITIC and a Ag contact layer 3 is finally deposited by, for example, thermal evaporation.

Figure 4 is a schematic illustration of an organic solar cell 17 according to some embodiments of the invention.

The organic solar cell 17 has a glass substrate 16 coated with a thin layer of ITO 15. A TiO₂ layer 14, 15 nm thick, is sputtered onto the conductive substrate according to the method of the first aspect of the invention.

A layer of perovskite 13 is deposited, by, for example, spin coating, onto the Ti oxide layer 14.

A passivation layer 12 is deposited onto the perovskite layer 13 to further suppress defects of the perovskite polycrystalline layer 13.

A further layer of Spiro-OMeTAD 11 as HTL material is further deposited onto the passivation layer 12 and a Au contact layer 10 is finally deposited by, for example, thermal evaporation.

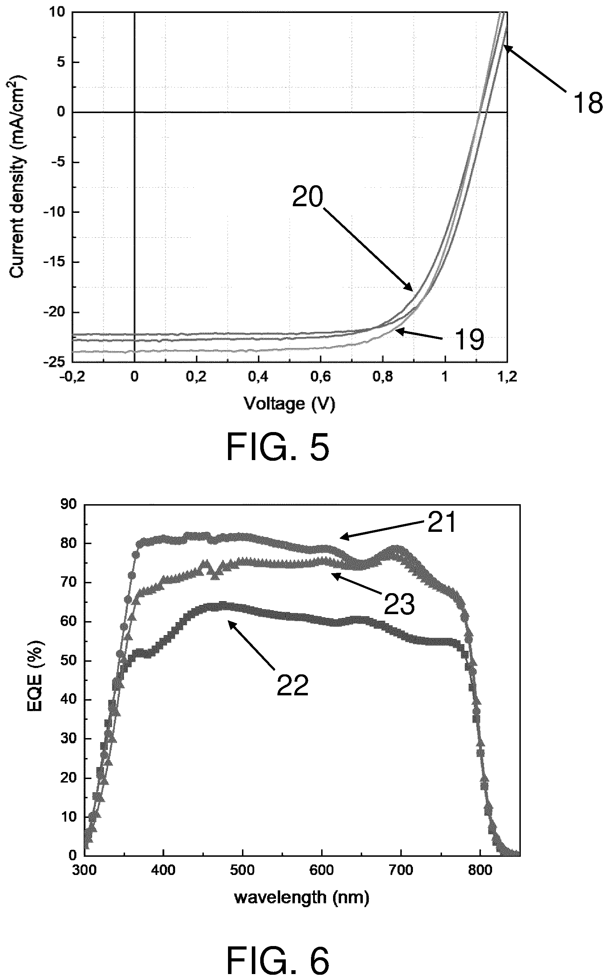

Figure 5 is a graph showing current-voltage (IV) characteristics of the solar cell 17 described by figure 4.

The graph compares the IV curves of a solar cell having the configurations as in figure 4 in which a layer of TiO₂ is deposited either through standard processing, i.e. line 18, through the method of the invention in which TiO₂ is sputtered keeping the temperature of the substrate at 150 ⁰C, i.e. line 19 or through the method of the invention in which TiO₂ is sputtered keeping the temperature of the substrate at 350 ⁰C, i.e. line 20.

Figure 6 is a graph showing the External Quantum Efficiency (EQE) vs wavelength of solar cell 17 as described in figure 4.

The graph compares as in figure 5, performances of a solar cell having the configurations as in figure 4 in which a layer of TiO₂ is deposited either through standard processing, i.e. line 22, through the method of the invention in which TiO₂ is sputtered keeping the temperature of the substrate at 150 ⁰C, i.e. line 23 or through the method of the invention in which TiO₂ is sputtered keeping the temperature of the substrate at 350 ⁰C, i.e. line 21.

Clearly better performances of energy conversion can be observed for the solar cell having a 15 nm TiO₂ layer sputtered through the method of the invention keeping the temperature of the substrate at 350 ⁰C.

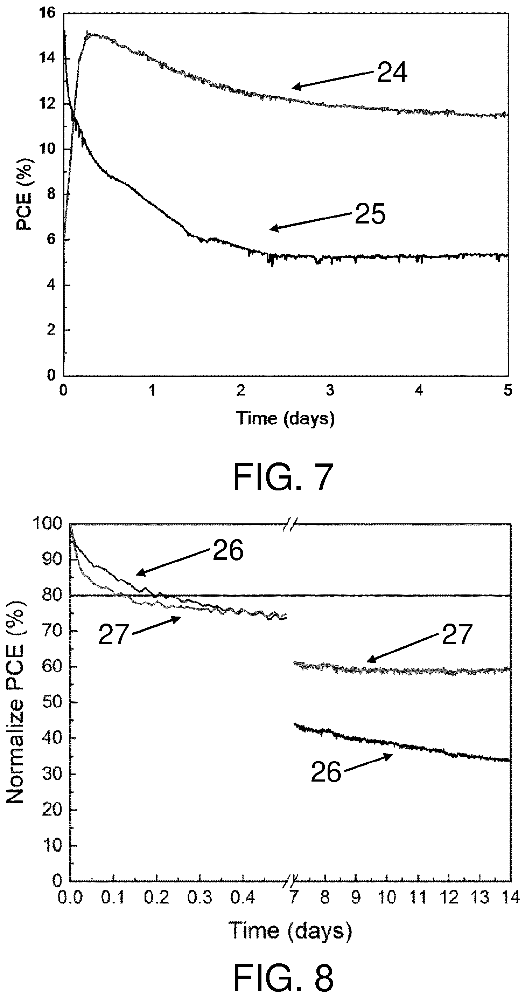

Figure 7 is a graph comparing the evolution of normalized PCE (stability) for a solar cell as described in figure 4 in which the layer of TiO₂ is deposited either through standard processing, i.e. line 25, or through the method of the invention in which TiO₂ is sputtered keeping the temperature of the substrate at 350 ⁰C, i.e. line 24.

From figure 7 it can be noticed that, through the method of the invention, the life time of the solar cell is improved as, after 5 days, the PCE of the solar cell sample having a 15 nm TiO₂ layer sputtered through the method of the invention is almost three times higher than the one of the solar cell sample in which the layer of TiO₂ is deposited through standard processing.

Figure 8 is a graph showing the evolution of normalized PCE (stability) for two solar cell, one using the TiO₂ of the invention, i.e. line 27 in a configuration as in figure 4, the other one using a standard ZnO layer, i.e. line 26 in a correspondent configuration.

Also in this case, through the method of the invention, the lifetime of the solra cell is improved as, after 14 days, the sample produced according to the method of the invention showed a normalized PCE of 60% compared to a PCE of 35% for a solar cell having a standard ZnO layer.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. In addition, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. A method of producing a solar cell, said method comprising
- producing a metal oxide layer on a substrate by
• providing a substrate into a deposition chamber;
• - heating said substrate at a predefined temperature for a predefined period of time and maintaining said heating;
• - introducing at least one carrier gas and at least one reacting gas comprising oxygen gas;
• - sputtering said metal oxide layer under a ratio of said carrier gas and said reacting gas, thereby forming said metal oxide layer of a desired thickness;
• - cooling said sputtered substrate to a preferred temperature and under a flow of at least one processing gas, such as said at least one carrier gas or said at least one reacting gas, for a preferred period of time, wherein said predefined period of time is between 1 and 120 minutes, thereby preventing formation of, or passivating possible surface defects of said sputtered metal oxide layer;
- depositing a layer of light harvesting material onto said metal oxide layer;
- depositing a contact layer onto said layer of light harvesting material;
- depositing a metal contact onto said contact layer.

2. A method according to claim 1, wherein said predefined temperature is between 100 ⁰C and 600 ⁰C, such as at 150 ⁰C, such as at 350 ⁰C.

3. A method according to any of the preceding claims, wherein said at least one carrier gas comprises argon.

4. A method according to any of the preceding claims, wherein said metal oxide is titanium oxide (TiOₓ).

5. A method according to any of the preceding claims, wherein said ratio is between 1% to 50% of reacting gas over reacting gas and carrier gas, such as 25%.

6. A method according to any of the preceding claims, wherein said preferred temperature is lower than 100 ⁰C.

7. A method according to any of the preceding claims, further comprising maintaining a pressure between 5x10⁻² and 3x10⁻⁴ mbar while sputtering.

8. A method according to any of the preceding claims, wherein said flow of said at least one processing gas is between 1 and 20 sccm, such as 5 sccm at a preferred pressure between 10⁻⁴ mbar and 10⁻² mbar, such as 10⁻³ mbar.

9. A method according to any of the preceding claims, wherein said deposition chamber is an ultra-high vacuum sputter deposition chamber.

10. A method according to any of the preceding claims, wherein said substrate is a transparent conductive substrate.

11. A solar cell, produced according to the method according to any of the preceding claims.

12. A solar cell according to claim 11, wherein the solar cell is a non-fullerene acceptor based organic solar cell.

## Patentansprüche

1. Verfahren zur Herstellung einer Solarzelle, wobei das Verfahren umfasst
- Herstellen einer Metalloxidschicht auf einem Substrat durch
• Bereitstellen eines Substrats in eine Abscheidungskammer;
• - Erhitzen des Substrats bei einer vordefinierten Temperatur für einen vordefinierten Zeitraum und Aufrechterhalten des Erhitzens;
• - Einleiten mindestens eines Trägergases und mindestens eines Reaktionsgases umfassend Sauerstoffgas;
• - Sputtern der Metalloxidschicht bei einem Verhältnis zwischen dem Trägergas und dem Reaktionsgas, wodurch die Metalloxidschicht mit einer gewünschten Dicke gebildet wird;
• - Abkühlen des gesputterten Substrats auf eine bevorzugte Temperatur und unter einem Strom mindestens eines Prozessgases, wie etwa des mindestens einen Trägergases oder des mindestens einen Reaktionsgases, für einen bevorzugten Zeitraum, wobei der vordefinierte Zeitraum zwischen 1 und 120 Minuten beträgt, wodurch ein Verhindern der Bildung von, oder ein Passivieren von möglichen Oberflächendefekten der gesputterten Metalloxidschicht erfolgt;
- Abscheiden einer Schicht aus lichtsammelndem Material auf die Metalloxidschicht;
- Abscheiden einer Kontaktschicht auf die Schicht aus lichtsammelndem Material;
- Abscheiden eines Metallkontakts auf die Kontaktschicht.

2. Verfahren nach Anspruch 1, wobei die vordefinierte Temperatur zwischen 100 °C und 600 °C liegt, wie etwa bei 150 °C, wie etwa bei 350 °C.

3. Verfahren nach einem der vorhergehenden Ansprüche, wobei das mindestens eine Trägergas Argon umfasst.

4. Verfahren nach einem der vorhergehenden Ansprüche, wobei das Metalloxid Titanoxid (TiOₓ) ist.

5. Verfahren nach einem der vorhergehenden Ansprüche, wobei das Verhältnis zwischen 1% und 50% Reaktionsgas bezogen auf Reaktionsgas und Trägergas beträgt, wie etwa 25%.

6. Verfahren nach einem der vorhergehenden Ansprüche, wobei die bevorzugte Temperatur niedriger als 100 °C ist.

7. Verfahren nach einem der vorhergehenden Ansprüche, ferner umfassend Aufrechterhalten eines Drucks zwischen 5x10⁻² und 3x10⁻⁴ mbar während des Sputterns.

8. Verfahren nach einem der vorhergehenden Ansprüche, wobei der Strom des mindestens einen Prozessgases zwischen 1 und 20 sccm beträgt, wie etwa 5 sccm bei einem bevorzugten Druck zwischen 10⁻⁴ mbar und 10⁻² mbar, wie etwa 10⁻³ mbar.

9. Verfahren nach einem der vorhergehenden Ansprüche, wobei die Abscheidungskammer eine Ultrahochvakuum-Sputterabscheidungskammer ist.

10. Verfahren nach einem der vorhergehenden Ansprüche, wobei das Substrat ein transparentes leitfähiges Substrat ist.

11. Solarzelle, hergestellt nach dem Verfahren nach einem der vorhergehenden Ansprüche.

12. Solarzelle nach Anspruch 11, wobei die Solarzelle eine organische Solarzelle auf Basis eines Nicht-Fulleren-Akzeptors ist.

## Revendications

1. Procédé de production d'une cellule solaire, ledit procédé comprenant
- la production d'une couche d'oxyde métallique sur un substrat par
• la fourniture d'un substrat dans une chambre de dépôt ;
• - le chauffage dudit substrat à une température prédéfinie pendant une période de temps prédéfinie et le maintien dudit chauffage ;
• - l'introduction d'au moins un gaz porteur et d'au moins un gaz réactif comprenant de l'oxygène gazeux ;
• - la pulvérisation cathodique de ladite couche d'oxyde métallique sous un rapport dudit gaz porteur et dudit gaz réactif, formant ainsi ladite couche d'oxyde métallique d'une épaisseur souhaitée ;
• - le refroidissement dudit substrat pulvérisé à une température préférée et sous un flux d'au moins un gaz de traitement, tel que ledit au moins un gaz porteur ou ledit au moins un gaz réactif, pendant une période de temps préférée, dans lequel ladite période de temps prédéfinie est comprise entre 1 et 120 minutes, empêchant ainsi la formation de, ou passivant d'éventuels défauts de surface de ladite couche d'oxyde métallique pulvérisée ;
- le dépôt d'une couche de matériau de captation de lumière sur ladite couche d'oxyde métallique ;
- le dépôt d'une couche de contact sur ladite couche de matériau de captation de lumière ;
- le dépôt d'un contact métallique sur ladite couche de contact.

2. Procédé selon la revendication 1, dans lequel ladite température prédéfinie est comprise entre 100 °C et 600 °C, telle qu'à 150 °C, telle qu'à 350 °C.

3. Procédé selon l'une quelconque des revendications précédentes, dans lequel ledit au moins un gaz porteur comprend de l'argon.

4. Procédé selon l'une quelconque des revendications précédentes, dans lequel ledit oxyde métallique est de l'oxyde de titane (TiOₓ).

5. Procédé selon l'une quelconque des revendications précédentes, dans lequel ledit rapport est entre 1% à 50% de gaz réactif sur gaz réactif et gaz porteur, tel que 25%.

6. Procédé selon l'une quelconque des revendications précédentes, dans lequel ladite température préférée est inférieure à 100 °C.

7. Procédé selon l'une quelconque des revendications précédentes, comprenant en outre le maintien d'une pression comprise entre 5x10⁻² et 3x10⁻⁴ mbar pendant la pulvérisation cathodique.

8. Procédé selon l'une quelconque des revendications précédentes, dans lequel ledit flux dudit au moins un gaz de traitement est compris entre 1 et 20 sccm, tel que 5 sccm à une pression préférée comprise entre 10⁻⁴ mbar et 10⁻² mbar, telle que 10⁻³ mbar.

9. Procédé selon l'une quelconque des revendications précédentes, dans lequel ladite chambre de dépôt est une chambre de dépôt par pulvérisation cathodique sous ultravide.

10. Procédé selon l'une quelconque des revendications précédentes, dans lequel ledit substrat est un substrat conducteur transparent.

11. Cellule solaire, produite selon le procédé selon l'une quelconque des revendications précédentes.

12. Cellule solaire selon la revendication 11, dans laquelle la cellule solaire est une cellule solaire organique à base d'accepteur non-fullerène.
